(19) Europäisches Patentamt
European Patent Office
Office européen des brevets

(11) EP 2 486 095 B1

(12) FASCICULE DE BREVET EUROPEEN

(45) Date de publication et mention de la délivrance du brevet:
**16.07.2014 Bulletin 2014/29**

(21) Numéro de dépôt: **10782333.8**

(22) Date de dépôt: **07.10.2010**

(51) Int Cl.:
***C08L 53/02*** *(2006.01)* ***C08F 293/00*** *(2006.01)*
***H01L 31/048*** *(2014.01)* ***B32B 17/10*** *(2006.01)*

(86) Numéro de dépôt international:
**PCT/FR2010/052113**

(87) Numéro de publication internationale:
**WO 2011/042665 (14.04.2011 Gazette 2011/15)**

(54) **MODULE PHOTOVOLTAÏQUE**

PV-MODUL

PHOTOVOLTAIC MODULE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.10.2009 FR 0957006**

(43) Date de publication de la demande:
**15.08.2012 Bulletin 2012/33**

(73) Titulaire: **Arkema France**
**92700 Colombes (FR)**

(72) Inventeurs:
- **GERARD, Pierre**
  **F-64230 Denguin (FR)**
- **BIZET, Stéphane**
  **F-27170 BARC (FR)**
- **JOUSSET, Dominique**
  **F-27470 Serquigny (FR)**

(74) Mandataire: **Albani, Dalila**
**Arkema France**
**Département Propriété Industrielle**
**420, rue d'Estienne d'Orves**
**92705 Colombes Cedex (FR)**

(56) Documents cités:
**EP-A1- 0 921 170**
**WO-A1-03/062293**
**FR-A1- 2 912 967**
**FR-A1- 2 921 068**
**US-A- 4 262 161**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).



Printed by Jouve, 75001 PARIS (FR)

## Description

La présente invention se rapporte à des modules solaires utilisant des compositions à base de copolymères à blocs acryliques utilisées dans l'encapsulation de leurs cellules photovoltaïques.

Les modules solaires suscitent un intérêt croissant, en raison du caractère renouvelable et non polluant de l'énergie ainsi obtenue. Un module solaire comprend une pile (ou cellule) photovoltaïque constituée de composants optoélectroniques (habituellement, à base de silicium cristallin), qui génère une tension électrique lors de l'exposition à la lumière. Les cellules photovoltaïques sont placées entre un matériau de couverture transparent, qui est une plaque en verre ou en plastique, et un matériau protecteur à l'arrière, souvent un film plastique. Dans la fabrication d'un module solaire, l'encapsulation a pour but de regrouper les cellules en série ou en parallèle afin de permettre leur utilisation à des tensions et des courants pratiques tout en assurant leur isolation électrique et leur protection contre les facteurs extérieurs (humidité, oxygène, variations de température). De plus, pour ne pas diminuer le rendement du module solaire, il est nécessaire que l'encapsulant permette la transmission des ondes lumineuses du rayonnement solaire vers les cellules. Toujours pour ne pas diminuer le rendement, il est souhaitable que ces ondes soient peu diffractées, c'est-à-dire que l'encapsulant doit être, à l'oeil nu, transparent, la transparence étant quantifiée par son « niveau de trouble » ou encore « Haze », qui doit être faible ou sa transmission lumineuse qui doit être la plus importante possible. Il est nécessaire également que l'encapsulant ait de bonnes propriétés d'isolation électrique, afin d'éviter tout court-circuit à l'intérieur du module. Le matériau d'encapsulation doit donc offrir une transparence optimale et durable au rayonnement solaire et une bonne adhésion des différentes couches à l'intérieur de la cellule photovoltaïque, et ceci tout au long de la vie du module solaire, qui doit être égale ou supérieure à 20 ans.

L'utilisation dans les modules solaires d'un encapsulant à base de copolymère d'éthylène - acétate de vinyle (EVA), décrit par exemple dans le document JP19870174967, constitue la solution la plus répandue à l'heure actuelle. L'EVA a une bonne transparence. Cependant, son adhérence avec les couches protectrices n'est pas satisfaisante et des agents d'aide à l'adhérence, communément appelés « agents de couplage », généralement choisis parmi les silanes ou les titanates organiques, doivent donc être ajoutés. De plus, l'EVA se dégrade sous l'influence du rayonnement solaire et de la température ; on observe alors un dégagement d'acide acétique corrodant les cellules photovoltaïques. Par ailleurs, on remarque également un vieillissement de l'encapsulant au cours du temps, qui se matérialise notamment par un jaunissement important, conduisant à une diminution du rendement du module solaire. En outre, la tenue au fluage de l'EVA n'est pas suffisante dans les conditions d'utilisation des modules solaires. Il est donc nécessaire que ce copolymère soit réticulé ; il n'est donc plus thermoplastique. Les modules sont alors plus difficiles à recycler après cette étape de réticulation de l'encapsulant. Par ailleurs, cette étape de réticulation constitue une étape supplémentaire dans le procédé de fabrication des modules solaires, ce qui conduit donc à une perte de productivité.

Pour éviter une étape de réticulation et pour résoudre les problèmes de propriétés thermomécaniques de l'encapsulant, notamment de tenue au fluage, il a été envisagé, dans le document WO95/22843, l'utilisation comme encapsulant d'ionomère dans les modules solaires. Cet ionomère est un copolymère thermoplastique, non réticulé, d'éthylène et d'acide (méth)acrylique partiellement neutralisé par des cations d'éléments des groupes I, II ou III du tableau périodique (par exemple de cation de Zinc ou de Calcium). L'adhérence de cet encapsulant avec la pile photovoltaïque et les couches de protection est correcte. Ces ionomères présentent également, à l'oeil nu, une bonne transparence. Cependant, bien que les propriétés thermomécaniques soient meilleures que celles de l'EVA non réticulé, la tenue au fluage n'est pas suffisante. En effet, la formation d'un réseau ionique permet à l'ionomère de conserver une certaine cohésion au-delà de sa température de fusion, mais sans que sa tenue au fluage soit pleinement satisfaisante. Un autre problème majeur de l'ionomère est sa viscosité élevée aux températures habituelles de fabrication des modules solaires (généralement comprises dans la gamme allant de 120°C à 160°C). Or, cette viscosité élevée est un frein à la productivité : en effet, dans un procédé continu de fabrication de film, par exemple un procédé de fabrication par extrusion, le débit de film en sortie d'extrudeuse diminue lorsque la viscosité augmente.

De même, dans les documents US 4.692.557 et WO 2006/093936 et pour les mêmes raisons que celles invoquées précédemment, il a été envisagé l'utilisation comme encapsulant de copolymères à blocs vinyliques et diéniques de type SEBS où S représente un bloc thermoplastique polystyrène et EB représente un bloc élastomère de butadiène partiellement hydrogéné (par exemple la gamme Kraton G® de la société Kraton). Cependant, la durabilité de tels matériaux, même additivés par des antioxydants, des absorbeurs UV et des stabilisants, n'est pas suffisante pour assurer une intégrité du module solaire sur 20 ans. Un vieillissement accéléré (supérieur à 10.000h) ou naturel (supérieur à 10 ans) d'un tel matériau entraînera une décoloration, une fragilisation ainsi qu'une perte des propriétés optiques de la couche d'encapsulant.

Dans le document US 6.414.236, l'encapsulant est un copolymère à blocs oléfines (par exemple la gamme Engage® ou Affinity® de la société Dow Chemical). Cet encapsulant est destiné à améliorer la tenue au vieillissement du module solaire. Cependant, sa résistance au fluage reste médiocre et sa réticulation est donc nécessaire : l'encapsulant n'est donc plus thermoplastique, ce qui affecte ses propriétés optiques et notamment sa transmission lumineuse.

Tout ou partie des inconvénients et problèmes présentés ci-dessus s'appliquent non seulement à tout type de

module solaire, mais également à tout autre type de cellule photovoltaïque et circuit intégré utilisant le silicium comme semi-conducteur.

Il existe donc un besoin de développer de nouveaux matériaux encapsulants qui pallient les inconvénients présentés par les matériaux d'encapsulation connus.

La présente invention se propose de fournir un module photovoltaïque qui utilise comme encapsulant une composition de copolymères à blocs acryliques ou méthacryliques qui présente de très bonnes propriétés de transparence, d'adhérence et de résistance au vieillissement sous rayonnement ultraviolet (UV) et ne nécessitant pas nécessairement de réticulation.

A cet effet, l'invention a pour objet un module photovoltaïque comprenant comme encapsulant une composition comprenant au moins un copolymère à blocs de type polyacrylate ou polyméthacrylate qui répond à la formule générale B-(A)n, n étant un entier naturel supérieur ou égal à un, de préférence compris entre 1 et 8, le bloc A étant choisi parmi les méthacrylates ayant une Tg supérieure à 0°C, le bloc B étant un polyacrylate ou un polyméthacrylate ayant une Tg inférieure à 0°C, le bloc B représentant au moins 50% en poids du poids total du copolymère à blocs.

De manière préférée, ledit copolymère à blocs contient un bloc polyacrylate de butyle et au moins un bloc polymethylméthacrylate.

De manière surprenante, cette composition combine d'excellentes propriétés de transparence, de résistance au vieillissement sous rayonnement ultraviolet, d'isolation électrique, de propriétés barrières à l'eau et l'oxygène, d'élasticité et de pouvoir adhésif, à des températures d'utilisation de l'ordre de 70°C voire plus, ces propriétés permettant son utilisation avantageuse dans les modules solaires.

Bien connu de l'homme de l'art, ladite composition est nanostructurée. On pourra se référer à l'article « Block Copolymers in Tomorrow's plastics », A.V. Ruzette et L. Leibler, Nature Materials, vol. 4, Jan. 2005, pp 19-31. Selon l'invention, on entend par composition nanostructurée une composition comprenant au moins deux phases non miscibles et dont au moins une de ces phases a une de ses dimensions (ou plus d'une) inférieure à 780 nm. Avantageusement, cette dimension est inférieure à 380nm, par exemple dans la gamme allant de 60 à 380 nm et mieux de 60 à 300 nm. Les dimensions des phases peuvent être aisément mesurées par l'homme du métier avec la technique connue de Microscopie Electronique à Transmission et un logiciel standard de traitement d'images.

Puisque la composition est nanostructurée, on obtient une composition qui transmet la lumière visible et/ou est transparente à la lumière visible selon la définition de l'invention, adhésive et ayant une très bonne tenue au fluage à des températures pouvant atteindre 70°C, voire plus. Combinées à ses propriétés barrière à l'eau, barrière aux gaz et ses propriétés électriques, cette composition thermoplastique peut être très avantageusement utilisée comme encapsulant dans le domaine des modules solaires, sans qu'il soit obligatoire d'effectuer une réticulation de la composition.

Dans le module photovoltaïque selon l'invention, la composition décrite ci-dessus est utilisée comme encapsulant. Cette composition est appliquée sur un support, formé par la couche supérieure ou inférieure de protection ou encore par la pile photovoltaïque. Ce support peut être constitué de verre, de polymère et en particulier de PMMA, de métal ou de tout type de capteur photovoltaïque. La structure formée par ladite composition appliquée sur un support présente une épaisseur comprise entre 5$\mu$m et 2mm.

<u>Description détaillée de l'invention</u>

La présente invention fournit un module photovoltaïque comprenant un matériau acrylique ayant à la fois de très bonnes propriétés de transparence qui restent constantes dans le temps et sur une large plage de températures (allant de la température ambiante jusqu'à 80°C), et qui garde de bonnes propriétés d'isolation électrique, de propriétés barrières à l'eau et l'oxygène, d'élasticité et de pouvoir adhésif. Ledit matériau se présente sous la forme d'une composition contenant au moins un copolymère à blocs polyacrylate ou polyméthacrylate. Cette composition est avantageusement utilisée comme encapsulant dans les modules solaires.

Les copolymères à blocs constituant la composition répondent à la formule générale B-(A)n, dans laquelle :

- n est un entier naturel supérieur ou égal à un, de préférence compris entre 1 et 8,
- B représente un bloc de polymère constitué de l'enchaînement de motifs monomères polymérisables par voie radicalaire, dont la Tg globale est inférieure à 0°C. La masse molaire moyenne du bloc B est supérieure à 1000 g/mol, de préférence supérieure à 5000 g/mol et encore plus préférentiellement supérieure à 10 000 g/mol,
- A est un bloc de polymère constitué de l'enchaînement de motifs monomères polymérisables par voie radicalaire, dont la Tg globale est supérieure à 0°C.

Les longueurs relatives des blocs A et B sont choisies telles que le rapport :

$$\frac{n^*Mn(B)}{n^*Mn(A) + Mn(B)}$$

soit compris entre 0,5 et 0,95, de préférence entre 0,6 et 0,8.
Mn désigne ici la masse moyenne en nombre du polymère ; le symbole « * » est utilisé pour désigner une opération de multiplication.

Le copolymère à blocs présente un indice de polydispersité Ip compris entre 1,1 et 3, avantageusement compris entre 1,3 et 2,5 et de préférence compris 1,5 et 2. Le bloc B présente un Ip inférieur à 1,5.

Le bloc B représente plus de 50% en poids du poids total du copolymère à blocs, et de préférence entre supérieur à 50 et 70%.

B est un bloc polymère obtenu par la polymérisation d'un mélange de monomères ($B_0$) contenant au moins 60% en poids de monomères acryliques ($b_1$).

Le mélange de monomères $B_0$ comprend de 60 à 100% en poids d'au moins un monomère acrylique ($b_1$) choisi parmi les acrylates d'alkyles ayant une chaîne alkyle comportant au moins deux atomes de carbone et de préférence au moins quatre atomes de carbone tels que l'acrylate de butyle, d'octyle, de nonyle, de 2-éthyl héxyle, les acrylate de polyéthylène glycol ou l'acrylonitrile. Les autres monomères, ($b_2$) entrant dans la constitution du bloc B sont choisis parmi les monomères polymérisables par voie radicalaire tels que les monomères éthyléniques, vinyliques et similaires.

En particulier, B est un polyacrylate ou un polyméthacrylate ayant une Tg inférieure à 0°C. De préférence, B contient des motifs acrylate de butyle. Tg désigne la température de transition vitreuse d'un polymère mesurée par DSC (calorimétrie à balayage différentiel) selon la norme ASTM E1356, par exemple avec des rampes de montée en température à 20°C par minute.

Le bloc A est obtenu par la polymérisation d'un mélange de monomères $A_0$ comprenant :

- de 60 à 100% en poids d'au moins un monomère méthacrylique (a1) choisi parmi les méthacrylates d'alkyles tels que de méthyle, de butyle, d'octyle, de nonyle, de 2-(éthyl héxyle), ou encore des méthacryliques fonctionnels tels que l'acide méthacrylique, le méthacrylate de glycidyle, le méthacrylonitrile ou tout méthacrylate comportant une fonction alcool, amide ou amine, et
- de 0 à 40 % en poids d'au moins un monomère ($a_2$) choisi parmi les anhydrides tels que l'anhydride maléique ou des monomères vinylaromatiques tels que le styrène ou ses dérivés, en particulier l'alpha méthylstyrène et les monomères répondant à b1.

De plus, on gardera éventuellement dans le mélange une proportion des monomères servant au bloc B. Celle-ci est au plus égale à 20% du mélange des monomères servant au bloc A.

Le bloc A est choisi de préférence parmi les méthacrylates ayant une Tg supérieure à 0°C. De préférence, A contient des motifs méthacrylate de méthyle.

Les copolymères à blocs entrant dans la composition selon l'invention sont préparés de manière connue par polymérisation radicalaire contrôlée, à partir d'au moins une alcoxyamine monofonctionnelle de formule (I) suivante :

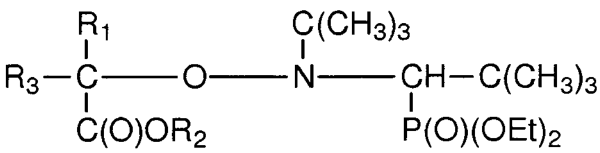

(I)

dans laquelle :

* $R_1$ et $R_3$, identiques ou différents, représentent un groupe alkyle, linéaire ou ramifié, ayant un nombre d'atomes de carbone allant de 1 à 3 ;
* $R_2$ représentant un atome d'hydrogène, un groupe alkyle, linéaire ou ramifié, ayant un nombre d'atomes de carbone allant de 1 à 8, un groupe phényle, un métal alcalin tel que Li, Na, K, un ion ammonium tel que $NH_4^+$, $NHBu_3^+$; de préférence $R_1$ étant $CH_3$ et $R_2$ étant H ; et/ou

- au moins une alcoxyamine polyfonctionnelle de formule (III) :

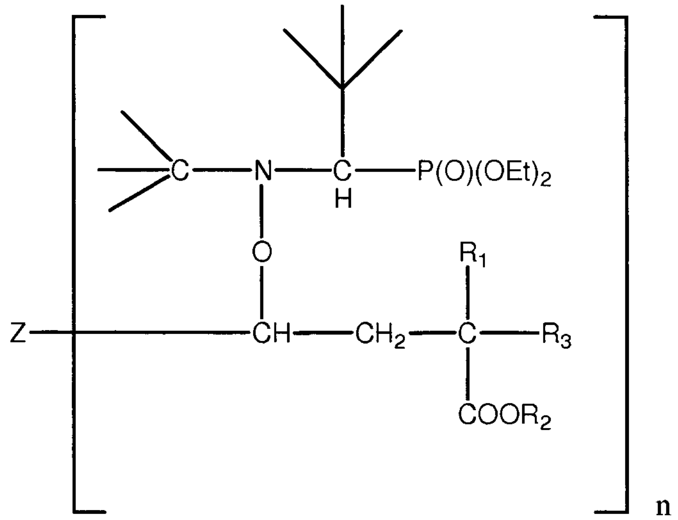

(III)

dans laquelle :

- $R_1$, $R_2$ et $R_3$ sont tels que définis ci-dessus ;
- Z représente un groupe aryle ou un groupe de formule $Z_1$-[X-C(O)]$_n$, dans laquelle $Z_1$ représente une structure polyfonctionnelle provenant par exemple d'un composé du type polyol, X est un atome d'oxygène, un atome d'azote porteur d'un groupement carboné ou d'un atome d'hydrogène, un atome de soufre ; et
- n est un nombre entier supérieur ou égal à 2 ;

La polymérisation est effectuée à des températures allant de 60 à 250°C, préférentiellement de 90 à 160°C, et à des pressions allant de 0,1 bar à 80 bars, de préférence de 0,5 bar à 10 bars. La polymérisation doit être contrôlée, et elle est arrêtée avant 99% de conversion, de préférence avant 90% de conversions du ou des monomère(s). Le bloc B ainsi obtenu est soit utilisé avec le résiduel de monomères soit purifié des monomères par distillation ou lavage et séchage avec un solvant non miscible avec B et miscible avec les monomères utilisés. La conversion massique du monomère varie de 10 à 100% et le copolymère à blocs obtenu est séparé des monomères résiduels par évaporation sous vide à des températures allant jusqu'à 250°C et préférentiellement jusqu'à 250°C.

Selon un mode de réalisation, le copolymère à blocs entrant dans la composition selon l'invention est copolymérisé avec un monomère méthacrylate ou acrylate, afin d'améliorer le pouvoir d'adhérence de la composition. Avantageusement, le copolymère à blocs contient jusqu'à 10% molaire de ces monomères, par exemple de 0,01 à 5% en mole et préférentiellement de 0,1 à 1%. Dans une variante de réalisation, ledit monomère contient des fonctions silanes.

De manière préférée, la composition comprend un monomère méthacrylate contenant des fonctions acides, anhydrides ou imidazolidones, agissant comme promoteur d'adhésion. Avantageusement, le copolymère à blocs contient jusqu'à 50% molaire de ces monomères, par exemple de 0,1 à 20% en mole et préférentiellement de 1 à 10%. Comme exemple, on pourra se référer à la gamme Norsocryl® de la société Arkema et notamment le mélange à 50% en poids de métahcrylate de méthyle et 50% en poids de méthacrylate de 2-(2-oxoimidazolidine)éthyle, référencé sous le nom commercial de Norsocryl 104®.

Avantageusement, la température d'écoulement du copolymère à blocs est la température de transition vitreuse du ou des blocs polyméthacrylate, mesurée par analyse thermomécanique suivant la norme ISO 11359-2. Selon l'invention, la température d'écoulement du copolymère à blocs est comprise dans la gamme allant de 80 à 150°C. Dans cette gamme de température d'écoulement, la composition présente une bonne tenue au fluage aux températures d'utilisation des modules solaires. Lorsqu'elle est utilisée pour la fabrication de structures comme les modules solaires, les gammes de température de fabrication de ces structures sont identiques à celles habituellement utilisées.

La composition qui sert d'encapsulant doit épouser parfaitement la forme de l'espace existant entre la pile photovoltaïque et les couches protectrices afin d'éviter la présence d'air, au cours de la fabrication du module solaire et au cours de son utilisation ce qui en limiterait son rendement. L'encapsulant doit ainsi avoir une flexibilité très élevée, correspondant à un module élastique de traction (ou Module d'Young) inférieur à 1000 MPa, par exemple de 1 à 700 MPa et de préférence entre 10 et 500 MPa.

La composition peut également comporter une résine tackifiante, un plastifiant ou un autre polymère, dit complémentaire. De préférence, ce polymère complémentaire est miscible ou partiellement miscible avec le copolymère à

bloc. Ce polymère complémentaire représente moins de 50% en poids de la masse totale de la composition et préférentiellement moins de 20% de la composition. Son utilisation diminue le prix de la composition. Dans le cas où ce polymère complémentaire est miscible ou partiellement miscible, la composition présente alors un excellent compromis coût/transmission de la lumière visible et/ou transparence à la lumière visible. De préférence, ce polymère complémentaire est du polyméthylméthacrylate (PMMA).

La composition comprend de manière avantageuse au moins 50%, préférentiellement au moins 65% et de manière encore plus préférée au moins 75% en masse de copolymères à blocs acryliques.

La composition peut comprendre en outre au moins un des composants additionnels choisis parmi les agents réticulants, les absorbants UV, les charges minérales, les plastifiants, les additifs retardateurs de flamme, les composés colorants ou azurants.

Lors de l'utilisation de la composition comme encapsulant dans un module solaire, la nature et/ou la concentration de ces composants doivent être telles que la composition finale reste transparente et/ou transmette la lumière visible. A titre d'exemple, ces composés peuvent représenter de 0 à 20% en poids de la masse totale de la composition, par exemple de 0,01 à 10%.

De manière caractéristique, la composition de l'invention transmet la lumière visible et/ou est transparente à la lumière visible. Selon l'invention, la composition transmet la lumière visible lorsqu'elle présente une transmission supérieure ou égale à 90% ; la composition est transparente à la lumière visible lorsqu'elle présente un niveau de trouble inférieur ou égal à 5%. La transmission et le niveau de trouble de la composition sont évalués selon la norme ASTM D1003, sur un film de ladite composition de 400 μm d'épaisseur et pour au moins une longueur d'onde du domaine visible (de 380 à 780 nm).

La composition serait également conforme à l'invention si elle comprenait un mélange de copolymères à blocs acryliques tels que définis précédemment

Parmi la liste d'additifs ci-après, l'homme du métier saura aisément sélectionner leurs quantités afin d'obtenir les propriétés voulues de la composition.

Des agents de couplage peuvent être avantageusement ajoutés afin d'améliorer le pouvoir d'adhérence de la composition lorsque celui-ci doit être particulièrement élevé. Selon l'invention, l'agent de couplage est un ingrédient non polymérique ; il peut être organique, cristallin et plus préférentiellement semi-cristallin semi-organique. Parmi ceux-ci, on peut citer les titanates ou les silanes organiques, comme par exemple les monoalkyl titanates, les trichlorosilanes et les trialkoxysilanes. Avantageusement, la composition comprend de 0 à 20% de la masse totale de la composition d'agents de couplage, par exemple de 0,01 à 10% en masse et préférentiellement de 0,1 à 5%.

Bien qu'une réticulation ne soit pas obligatoire, celle-ci est possible pour encore améliorer les propriétés thermomécaniques de l'encapsulant, en particulier lorsque la température devient très élevée. On ne sort donc pas du cadre de l'invention si des agents réticulant sont ajoutés. On peut citer comme exemples des isocyanates ou des peroxydes organiques. Cette réticulation peut également être réalisée par des techniques connues d'irradiation.

Le rayonnement UV entraînant un jaunissement de l'encapsulant, des stabilisants UV peuvent être ajoutés afin d'assurer la transparence de l'encapsulant durant sa durée de vie. Ces composés peuvent être par exemple à base de benzophénone ou de benzotriazole. On peut les ajouter dans des quantités inférieures à 10% en masse de la masse totale de la composition et préférentiellement de 0,1 à 5%.

Des charges, en particulier minérales, peuvent être ajoutées pour améliorer la tenue thermomécanique de la composition. De façon non limitative, on donnera comme exemples la silice, l'alumine ou les carbonates de calcium ou les nanotubes de carbone. Avantageusement, on utilise des argiles modifiées ou non modifiées qui sont mélangées à l'ordre nanométrique ; ceci permet d'obtenir une composition plus transparente.

Des plastifiants pourront être ajoutés afin de faciliter la mise en oeuvre et améliorer la productivité du procédé de fabrication de la composition et des structures. On citera comme exemples les huiles minérales paraffiniques aromatiques ou naphtaléniques qui permettent également d'améliorer le pouvoir d'adhérence de la composition selon l'invention. On peut également citer comme plastifiant les phtalates, azelates, adipates, le phosphate de ticrésyle.

Des agents retardateurs de flamme pourront également être ajoutés.

On pourra également ajouter des composés colorants ou azurants.

Dans le module photovoltaïque selon l'invention, la composition décrite ci-dessus peut être avantageusement utilisée comme encapsulant. Cette composition est appliquée sur un support, formé par la couche supérieure ou inférieure de protection ou encore par la pile photovoltaïque. Ce support peut être constitué de verre, de polymère et en particulier de PMMA, de métal ou de tout type de capteur photovoltaïque. La structure formée par ladite composition appliquée sur un support présente une épaisseur comprise entre 5μm et 2mm.

Préférentiellement, la structure a une épaisseur comprise entre 5 μm et 2 mm, préférentiellement entre 100μm et 1 mm et encore plus préférentiellement entre 300 et 500 μm. Ces structures peuvent prendre en particulier la forme d'un film. Ces films pourront être avantageusement utilisés pour l'encapsulation des cellules solaires. Ces structures peuvent être monocouches ou multicouches. Pour ces dernières, on peut par exemple associer à la couche de la composition selon l'invention un support, ce support pouvant comprendre des polymères. Comme exemple de polymères,

on peut citer les polyoléfines, comme par exemple l'EVA, ces polyoléfines comprenant ou non un monomère insaturé, les ionomères, les polyamides, les polymères fluorés (comme le polyfluorure de vinyle PVF ou le polyflurorure de divinyle PVDF) ou le poly méthacrylate de méthyle (PMMA). On peut également citer comme autre support ceux à partir de métaux ou de tout type de cellule photovoltaïque.

Ces structures peuvent être obtenues à partir de la composition décrite ci-dessus par les techniques classiques de pressage, d'injection, d'extrusion soufflage de gaine, d'extrusion lamination, d'extrusion couchage, d'extrusion à plat (encore appelée « extrusion cast ») ou encore d'extrusion de feuille par calandrage, toutes ces structures pouvant être éventuellement thermoformées par la suite

Généralement, pour former un module solaire, on place successivement sur un backsheet (ou couche arrière), une première couche d'encapsulant inférieure, une pile photovoltaïque, une seconde couche d'encapsulant supérieure puis une couche protectrice supérieure. On peut trouver en outre des couches additionnelles, et en particulier des couches de liants ou d'adhésifs. Ces différentes couches sont assemblées pour former le module. Il est précisé que les modules photovoltaïques selon l'invention peuvent être constitués de toute structure photovoltaïque comprenant une couche de la composition décrite ici et ne sont bien évidemment pas limités à ceux présentés dans cette description.

Pour former la pile photovoltaïque, on peut utiliser tout type de capteurs photovoltaïques parmi lesquelles les capteurs dits « classiques » à base de silicium dopé, monocristallin ou polycristallin ; les capteurs en couche mince formées par exemple de silicium amorphe, de tellurure de cadnium, de disiléniure de cuivre-indium ou de matériaux organiques peuvent également être utilisés.

Comme exemples de backsheet que l'on peut utiliser dans les modules solaires, on peut citer de manière non exhaustive des films à base de polymère fluoré (PVF ou PVDF), comme par exemple les films multicouches polymère fluoré/polyéthylène téréphtalate/polymère fluoré ou encore polymère fluoré/polyéthylène téréphtalate/EVA.

La plaque protectrice a des propriétés de résistance à l'abrasion et au choc, est transparente et protège les capteurs photovoltaïques de l'humidité extérieure. Pour former cette couche, on peut citer le verre, le PMMA ou toute autre composition polymère réunissant ces caractéristiques.

Pour assembler les différentes couches, on peut utiliser tous les types de techniques de pressage comme par exemple le pressage à chaud, le pressage sous vide ou le laminage, en particulier le thermolaminage. Les conditions de fabrication seront aisément déterminées par l'homme du métier en ajustant la température et la pression à la température d'écoulement de la composition.

Pour fabriquer les modules solaires selon l'invention, l'homme du métier peut se référer par exemple au Handbook of Photovoltaic Science and Engineering, Wiley, 2003.

La présente invention va être maintenant illustrée par des exemples particuliers de réalisation décrits ci-après. Il est précisé que ces exemples ne visent en aucun cas à limiter la portée de la présente invention.

## Exemples de réalisation

Les abréviations suivantes apparaîtront dans la description des exemples :

ABU : Acrylate de butyle
MMA : Méthacrylate de méthyle
MEIO : Méthacrylate de 2-(2-oxoimidazolidine)éthyle
EVA : copolymère d'éthylène - acétate de vinyle
Ip : indice de polymolécularité
Mw : masse moléculaire moyenne en poids
Mp : masse moléculaire au pic de la distribution
Mn : masse moléculaire moyenne en nombre.

Les caractérisations des matériaux sont faites selon des méthodes standards d'analyse. Les masses moléculaires sont déterminées à l'aide de la chromatographie d'exclusion stérique et sont exprimées en équivalents polystyrène. La composition en monomères du copolymère à blocs est mesurée par résonance magnétique nucléaire. En outre, la teneur en copolymère séquencé de la composition est mesurée par une technique appelée chromatographie d'absorption liquide.

## Préparation du diblocs (exemple 1)

1 copolymère diblocs polyacrylate de butyle - polyméthacrylate de méthyle (PABU-PMMA) a été synthétisé par polymérisation radicalaire contrôlée (PRC).

1) Synthèse du premier bloc PAbu

Le PABU a été synthétisé dans un réacteur de 20 1 en l'absence de solvant en utilisant comme amorceur une alcoxyamine répondant à la formule (I) et connue commercialement sous le nom BlocBuilder®. La masse moléculaire Mn visée est de 25000. Le taux de conversion visé est de 90%. La température de polymérisation est de 115°C. Le temps de polymérisation est de 115 minutes.

Lorsque les copolymères à blocs nécessitent un stripping du PABU pour augmenter la transition vitreuse du deuxième bloc PMMA, celui-ci a été réalisé à une température de 80°C, pendant une durée de 180 minutes, dans le réacteur de 20 1.

2) Synthèse du deuxième bloc PMMA

Le bloc PMMA a été synthétisé dans le même réacteur de 201, à partir du PABU synthétisé au cours de la première étape, en rajoutant du MMA monomère et du toluène. Le temps de polymérisation se décompose en 2 paliers successifs : 120 minutes à 105°C et 120 minutes à 120°C.

Préparation du triblocs (exemple 2)

Le copolymère triblocs polyméthylméthacrylate - b - polybutylacrylate - b - polyméthylméthacrylate a été obtenu par la technique de polymérisation radicalaire contrôlée suivant le même protocole que celui décrit pour la synthèse du copolymère diblocs mais en remplaçant le BlocBuilder par une alcoxyamine difonctionnelle telle que la DIAMINS indiquée plus bas et en introduisant dans le réacteur lors de la synthèse des blocs méthacrylates un mélange contenant 90% en poids de méthacrylate de méthyle et 10% en poids de Norsocryl104, qui est un mélange à 50% en poids de métahcrylate de méthyle et 50% en poids de méthacrylate de 2-(2-oxoimidazolidine)éthyle (MEIO).

La récupération du produit se fait simplement par séchage du polymère selon un moyen connu de l'homme de l'art. Lors de cette étape, on ajoute les divers additifs nécessaires à la protection UV et thermique requise pour l'application encapsulant de cellule photovoltaïque.

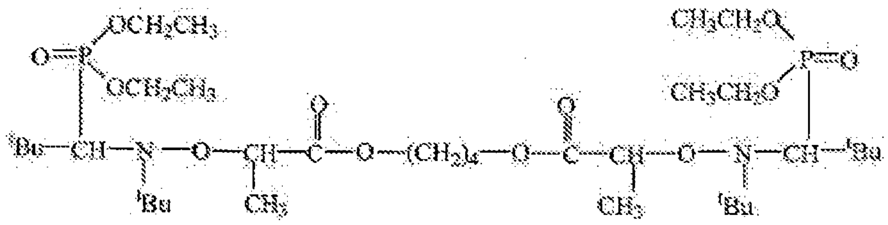

DIAMINS

Les conditions de synthèse et les propriétés des copolymères obtenus sont données dans le Tableau I ci-après.

Tableau I

| Référence échantillon copolymère | Exemple 1 | Exemple 2 |
|---|---|---|
| Volume réacteur (1) | 20 | 20 |
| Composition en monomères visée (%) :<br>- ABU<br>- MMA<br>- MEIO | <br>55<br>45<br> | <br>55<br>40<br>5 |
| Architecture du copolymère | diblocs | triblocs |
| PABU | Non strippé | Strippé |
| Composition en monomères par RMN (%) :<br>- ABU<br>- MMA<br>- MEIO | <br>52<br>48<br> | <br>57<br>39<br>4 |
| Masse PABU :<br>- Mp | <br>35590 | <br>64500 |

(suite)

| | | |
|---|---|---|
| Masse PABU :<br>- Mn<br>- Mw | <br>26140<br>36760 | <br>42350<br>74950 |
| Ip | 1,41 | 1,77 |
| Masse copolymère :<br>- Mn<br>- Mp<br>- Mw | <br>51030<br>33910<br>56630 | <br>110630<br>72390<br>143000 |

Afin de montrer les propriétés intéressantes des compositions selon l'invention et leur utilisation avantageuse dans les modules solaires, on a également utilisé les compositions comparatives (CP) suivantes :

CP1 : Composition à base d'ionomère.

CP2 : Composition à base de copolymère EVA comprenant 33% en masse d'acétate de vinyle et ayant un MFI de 45 g/10 min (ASTM D 1238 - 190°C - 2,16 kg) et un peroxyde organique.

Les films sont réalisés avec une extrudeuse de laboratoire RHEOCORD à vis thermoplastique, à travers une filière plate. Les films passent ensuite dans une calandre thermorégulée à 3 rouleaux puis sont refroidis dans un bain d'eau.

Avant extrusion, les échantillons sont étuvés sous vide à 80°C pendant 3h minimum.
Températures extrudeuse zones 1,2,3 : 175°C
Températures filière zone 4 : 190°C
Vitesse vis : 33 t/min.
Distance filière/ axe rouleau calandre : au contact
Entrefer filière : 0.1mm
Epaisseur des films : 400 μm

La vis est purgée 1 trémie avant prélèvement ou démontée et nettoyée.

Le film de la composition CP2 est postérieurement réticulé par un traitement thermique à 150°C pendant 20min sous presse.

Les films ainsi obtenus ont été évalués mécaniquement et optiquement suivant les normes respectives :

- Norme ASTM D882 : détermination des propriétés en traction sur films ;
- Norme ASTM D1003 : détermination de la transmission lumineuse totale et du trouble (Trouble).

Une analyse par microscope à force atomique (Digital Instrument *Dimension 3100*) a permis de valider le fait que la taille des domaines de basse Tg est bien inférieure à 100 nm.

La résistivité électrique transversale a été déterminée à 23°C à l'aide d'un spectromètre diélectrique de type Novocontrol Concept 40. Pour chaque, température un balayage en fréquence a été réalisé entre 0.1 Hz et $10^6$ Hz. On a reporté la résistivité des échantillons à basse fréquence (0,1 Hz), lorsque cette résistivité est indépendante de la fréquence.

La tenue au fluage à 100°C a été déterminée sur des éprouvettes de type IFC découpées dans les films. Le test consiste à appliquer une contrainte de 0,5 MPa pendant 15min à une température donnée et de mesurer l'allongement résiduel après retour à température ambiante.

Le film de l'exemple 2 a été pressé sur une plaque de verre de dimensions 200(longueur)×50(largeur)×3(épaisseur) $mm^3$ à 150°C sous 3 bars de pression pendant 20min. L'adhésion est évaluée à partir d'un test de pelage à 90° effectué à 100mm/min sur un dynamomètre Zwyck 1445 et selon la norme ISO8510-1. La largeur du bras de pelage est de 15mm. Lors des tests, on mesure uniquement la résistance au pelage entre le support en verre et la composition de l'exemple 2.

Les résultats obtenus sont reportés dans le Tableau II.

Tableau II

| | Module (Mpa) | Transmission lumineuse (%) | Résistivité électrique transversale (Ω.m) à 23°C | Tenue au fluage (%) | Adhésion sur verre (force de pelage en N/15mm) |
|---|---|---|---|---|---|
| Ex1 | 240 | > 94 | $10^{13}$ | > 200 | Non mesuré |
| Ex2 | 60 | > 94 | $10^{13}$ | 37 | 100 |
| CP1 | 600 | 90 | $3.10^{14}$ | > 300 | Non mesuré |
| CP2 | 120 | 91 | $10^{13}$ | 10 | 110 |

Ces résultats montrent que :

- les compositions selon l'invention (Ex1 et Ex2) ont une transmission lumineuse très largement supérieure à celle des ionomères (CP1), qui est également un matériau thermoplastique et à celle de l'EVA réticulé (CP2), ce qui permettra d'obtenir un rendement de production du module solaire supérieur ;
- les compositions selon l'invention (Ex1 et Ex2) ont la flexibilité requise pour la fabrication de modules solaires et leur utilisation ainsi qu'une tenue au fluage à 100°C supérieure à celle des ionomères (CP1), le test n'ayant par permis la mesure de l'allongement car l'ionomère flue de manière trop importante (>300%) ;
- la résistivité des échantillons selon l'invention est similaire à celle observée pour la composition comparative à base d'EVA réticulé ;
- l'adhésion sur verre d'un échantillon selon l'invention est similaire à celle observée pour la composition comparative à base d'EVA réticulé.

Les compositions selon l'invention remplissent donc les critères pour pouvoir être très avantageusement utilisée comme liant ou encapsulant dans les modules solaires.

**Revendications**

1. Module photovoltaïque comprenant comme encapsulant une composition comprenant un copolymère à blocs de type polyacrylate ou polyméthacrylate qui répond à la formule générale B-(A)n, n étant un entier naturel supérieur ou égal à un, de préférence compris entre 1 et 8, le bloc A étant choisi parmi les méthacrylates ayant une Tg supérieure à 0°C, le bloc B étant un polyacrylate ou un polyméthacrylate ayant une Tg inférieure à 0°C, le bloc B représentant au moins 50% en poids du poids total du copolymère à blocs.

2. Module photovoltaïque selon la revendication 1 dans lequel ledit bloc B contient des motifs acrylate de butyle et ledit bloc A contient des motifs méthacrylate de méthyle.

3. Module photovoltaïque selon l'une quelconque des revendications 1 et 2 dans lequel ledit copolymère à blocs comprend un monomère méthacrylate contenant des fonctions acides, anhydrides ou imidazolidones.

4. Module photovoltaïque selon l'une quelconque des revendications 1 à 3 dans lequel ladite composition comprend en outre au moins un agent de couplage.

5. Module photovoltaïque selon l'une quelconque des revendications 1 à 4, dans lequel ladite composition comprend en outre une résine tackifiante, un plastifiant ou un autre polymère, dit complémentaire qui est miscible ou partiellement miscible avec le copolymère à blocs acryliques.

6. Module photovoltaïque selon l'une quelconque des revendications 1 à 5, dans lequel ladite composition comprend en outre au moins un des composants additionnels choisis parmi les agents réticulants, les absorbants UV, les charges minérales, les plastifiants, les matières colorantes, les azurants optiques et les agents ignifugeants.

7. Module photovoltaïque selon l'une quelconque des revendications 1 à 6, dans lequel ladite composition comprend au moins 50% en masse dudit copolymère à blocs acryliques.

8. Module photovoltaïque selon l'une quelconque des revendications 1 à 7, dans lequel le copolymère à blocs a un module de Young inférieur à 1000 MPa, de préférence entre 1 et 700 MPa et encore plus préférentiellement entre

10 et 500 Mpa.

**9.** Module photovoltaïque selon l'une quelconque des revendications 1 à 8, dans lequel ladite composition comprend en outre le copolymère à blocs est résistant au jaunissement provoqué par les UV.

**10.** Module photovoltaïque selon l'une quelconque des revendications 1 à 9, dans lequel la température d'écoulement du copolymère à blocs est la température de transition vitreuse du ou des blocs polyméthacrylate et est comprise entre 80 et 150°C.

**11.** Module photovoltaïque selon l'une quelconque des revendications 1 à 10, dans lequel pour un film de ladite composition d'une épaisseur de 400μm et une onde électromagnétique d'une longueur d'onde allant de 380 à 780 nm, la transmission de ladite onde est supérieure ou égale à 90% et/ou le niveau de trouble inférieur ou égal à 5%, la transmission et le niveau de trouble du film étant mesurés selon la norme ASTM D1003.

**12.** Module photovoltaïque selon l'une quelconque des revendications 1 à 11, dans lequel ladite composition comprend un copolymère diblocs PMMA-b-PABU (polyméthacrylate de méthyle - b- polyacrylate de butyle) dont la composition en monomères telle que déterminée par résonance magnétique nucléaire est de 52% ABU et 48% MMA.

**13.** Module photovoltaïque selon l'une quelconque des revendications 1 à 11, dans lequel ladite composition comprend un copolymère triblocs PMMA-b-PABU-b-PMMA dont la composition en monomères telle que déterminée par résonance magnétique nucléaire est de 57% ABU, 39% MMA et 4% MEIO.

**14.** Module photovoltaïque selon l'une quelconque des revendications 1 à 11, dans lequel ladite composition est appliquée sur un support, sous forme d'une couche dont l'épaisseur est de 5μm à 2mm.

**15.** Module photovoltaïque selon la revendication 14 dans lequel ledit support est constitué de verre, de polymère et en particulier de PMMA, de métal ou de tous types de capteurs photovoltaïques.

## Patentansprüche

**1.** Photovoltaikmodul, das als Verkapselungsmittel eine Zusammensetzung umfasst, die ein Blockcopolymer vom Polyacrylattyp oder Polymethacrylattyp enthält, das der allgemeinen Formel B-(A)n entspricht, wobei n eine natürliche Zahl größer oder gleich 1 und vorzugsweise zwischen 1 und 8 bedeutet, der Block A unter den Methacrylaten mit einer Tg über 0 °C ausgewählt ist und der Block B ein Polyacrylat oder Polymethacrylat mit einer Tg unter 0 °C ist, wobei der Block B mindestens 50 Gew.-% des Gesamtgewichts des Blockcopolymers ausmacht.

**2.** Photovoltaikmodul nach Anspruch 1, wobei der Block B Butylacrylateinheiten aufweist und der Block A Methylmethacrylateinheiten aufweist.

**3.** Photovoltaikmodul nach einem der Ansprüche 1 und 2, wobei das Blockcopolymer ein Methacrylatmonomer enthält, das Säurefunktionen, Anhydridfunktionen oder Imidazolidonfunktionen aufweist.

**4.** Photovoltaikmodul nach einem der Ansprüche 1 bis 3, wobei die Zusammensetzung ferner mindestens ein Kupplungsmittel enthält.

**5.** Photovoltaikmodul nach einem der Ansprüche 1 bis 4, wobei die Zusammensetzung ferner ein Klebrigmacherharz, einen Weichmacher oder ein anderes, als komplementär bezeichnetes Polymer enthält, das mit dem Copolymer mit Acrylblöcken mischbar oder zum Teil mischbar ist.

**6.** Photovoltaikmodul nach einem der Ansprüche 1 bis 5, wobei die Zusammensetzung ferner eine zusätzliche Komponente enthält, die unter den Vernetzungsmitteln, UV-Absorbern, anorganischen Füllstoffen, Weichmachern, Farbmitteln, optischen Aufhellern und Flammschutzmitteln ausgewählt ist.

**7.** Photovoltaikmodul nach einem der Ansprüche 1 bis 6, wobei die Zusammensetzung zumindest 50 Masse-% des Copolymers mit Acrylblöcken enthält.

**8.** Photovoltaikmodul nach einem der Ansprüche 1 bis 7, wobei das Blockcopolymer einen Elastizitätsmodul unter

1000 MPa, vorzugsweise zwischen 1 und 700 MPa und nach bevorzugter zwischen 10 und 500 MPa aufweist.

**9.** Photovoltaikmodul nach einem der Ansprüche 1 bis 8, wobei die Zusammensetzung, die auch das Blockcopolymer enthält, beständig gegenüber durch UV-Strahlung hervorgerufenes Vergilben ist.

**10.** Photovoltaikmodul nach einem der Ansprüche 1 bis 9, wobei die Fließtemperatur des Blockcopolymers die Glasübergangstemperatur des oder der Polymethacrylatblöcke ist und zwischen 80 und 150 °C liegt.

**11.** Photovoltaikmodul nach einem der Ansprüche 1 bis 10, wobei für eine Folie der Zusammensetzung mit einer Dicke von 400 μm und bei einer elektromagnetischen Strahlung mit einer Wellenlänge von 380 bis 780 nm die Transmission für die Strahlung größer oder gleich 90 % ist und/oder der Trübungsgrad kleiner oder gleich 5 % ist, wobei die Transmission und der Trübungsgrad der Folie gemäß der Norm ASTM D 1003 gemessen werden.

**12.** Photovoltaikmodul nach einem der Ansprüche 1 bis 11, wobei die Zusammensetzung ein Zweiblock-Copolymer PMMA-b-PABU (Polymethylmethacrylat-b-Polybutylacrylat) enthält, dessen mit Kernspinresonanz bestimmte Monomerenzusammensetzung 52 % ABU und 48 % MMA ist.

**13.** Photovoltaikmodul nach einem der Ansprüche 1 bis 11, wobei die Zusammensetzung ein Dreiblock-Copolymer PMMA-b-PABU-b-PMMA enthält, dessen mit Kernspinresonanz bestimmte Monomerenzusammensetzung 57 % ABU, 39 % MMA und 4 % MEIO ist.

**14.** Photovoltaikmodul nach einem der Ansprüche 1 bis 11, wobei die Zusammensetzung in Form einer Schicht mit einer Dicke von 5 μm bis 2 mm auf einen Träger aufgebracht wird.

**15.** Photovoltaikmodul nach Anspruch 14, wobei der Träger aus Glas, Polymer und insbesondere PMMA, Metall oder allen Arten von photovoltaischen Zellen besteht.

## Claims

**1.** A photovoltaic module comprising, as an encapsulant, a composition comprising a polyacrylate- or polymethacrylate-type block copolymer which corresponds to the general formula B-(A)n, n being a natural integer greater than or equal to one, preferably between 1 and 8, block A being chosen from methacrylates having a Tg above 0°C, block B being a polyacrylate or a polymethacrylate having a Tg below 0°C, block B representing at least 50% by weight of the total weight of the block copolymer.

**2.** The photovoltaic module as claimed in claim 1, in which said block B contains butyl acrylate units and said block A contains methyl methacrylate units.

**3.** The photovoltaic module as claimed in either one of claims 1 and 2, in which said block copolymer comprises a methacrylate monomer containing acid, anhydride or imidazolidone functions.

**4.** The photovoltaic module as claimed in any one of claims 1 to 3, in which said composition also comprises at least one coupling agent.

**5.** The photovoltaic module as claimed in any one of claims 1 to 4, in which said composition also comprises a tackifying resin, a plasticizer or another polymer, termed supplementary polymer, which is miscible or partially miscible with the acrylic block copolymer.

**6.** The photovoltaic module as claimed in any one of claims 1 to 5, in which said composition also comprises at least one of the additional components chosen from crosslinking agents, UV absorbants, inorganic fillers, plasticizers, dyestuffs, optical brighteners and flame retardants.

**7.** The photovoltaic module as claimed in any one of claims 1 to 6, in which said composition comprises at least 50% by mass of said acrylic block copolymer.

**8.** The photovoltaic module as claimed in any one of claims 1 to 7, in which the block copolymer has a Young's modulus of less than 1000 MPa, preferably between 1 and 700 MPa and even more preferentially between 10 and 500 Mpa.

**9.** The photovoltaic module as claimed in any one of claims 1 to 8, in which said composition also comprising the block copolymer is resistant to yellowing caused by UV radiation.

**10.** The photovoltaic module as claimed in any one of claims 1 to 9, in which the flow temperature of the block copolymer is the glass transition temperature of the polymethacrylate block(s) and is between 80 and 150°C.

**11.** The photovoltaic module as claimed in any one of claims 1 to 10, in which, for a film of said composition with a thickness of 400 μm and an electromagnetic wave with a wavelength ranging from 380 to 780 nm, the transmittance of said wave is greater than or equal to 90% and/or the haze less than or equal to 5%, the transmittance and the haze of the film being measured according to standard ASTM D1003.

**12.** The photovoltaic module as claimed in any one of claims 1 to 11, in which said composition comprises a PMMA-b-PBuA (poly(methyl methacrylate)-b-poly(butyl acrylate)) diblock copolymer, the monomer composition of which as determined by nuclear magnetic resonance is 52% BuA and 48% MMA.

**13.** The photovoltaic module as claimed in any one of claims 1 to 11, in which said composition comprises a PMMA-b-PBuA-b-PMMA triblock copolymer, the monomer composition of which as determined by nuclear magnetic resonance is 57% BuA, 39% MMA and 4% MEIO.

**14.** The photovoltaic module as claimed in any one of claims 1 to 11, in which said composition is applied to a support, in the form of a layer of which the thickness is from 5 μm to 2 mm.

**15.** The photovoltaic module as claimed in claim 14, in which said support consists of glass, polymer and in particular PMMA, metal or any type of photovoltaic sensor.

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- JP 19870174967 B
- WO 9522843 A
- US 4692557 A
- WO 2006093936 A
- US 6414236 B


### Littérature non-brevet citée dans la description


- **A.V. RUZETTE ; L. LEIBLER.** Block Copolymers in Tomorrow's plastics. *Nature Materials,* Janvier 2005, vol. 4, 19-31
- Handbook of Photovoltaic Science and Engineering. Wiley, 2003